# EUROPÄISCHE PATENTSCHRIFT

(11) **EP 2 356 891 B1**
(45) Veröffentlichungstag und Bekanntmachung des Hinweises auf die Patenterteilung: **05.09.2012**
(21) Anmeldenummer: 09798907.3
(22) Anmeldetag: 07.12.2009
(51) Int. Cl.: H05K 7/12, H01G 2/06

(54) **ELEKTRISCHES GERÄT**
ELECTRICAL APPLIANCE
APPAREIL ÉLECTRIQUE

(30) Priorität: 09.12.2008 DE 102008061234
(43) Veröffentlichungstag der Anmeldung: 17.08.2011
(73) Patentinhaber: Kostal Kontakt Systeme GmbH, 58513 Lüdenscheid (DE)
(72) Erfinder: HINTERESCH, Klaus, 58239 Schwerte (DE); KOSTER, Werner, 58579 Schalksmühle (DE); KNOBLOCH, Rüdiger, 58509 Lüdenscheid (DE)
(74) Vertreter: Kerkmann, Detlef
(86) Internationale Anmeldenummer: PCT/EP2009/066557
(87) Internationale Veröffentlichungsnummer: WO 2010/066694

(56) Entgegenhaltungen:
- CA-A1- 1 023 798
- DE-A1- 19 829 920
- US-A- 5 044 988
- US-A- 5 171 165
- US-A- 5 707 249

## Beschreibung

Die vorliegende Erfindung betrifft ein elektrisches Gerät mit einem Gehäuse und einer am Gehäuse mechanisch gehaltenen Leiterplatte, und mit mindestens einem am Gehäuse mechanisch gehaltenen elektrischen oder elektronischen Bauelement, von dessen Anschlüssen wenigstens einer über einen Schneidklemmkontakt, der zugleich Einpresskontakte ausbildet, elektrisch mit der Leiterplatte verbunden ist, wobei das Gehäuse mindestens einen angeformten Einschub zur Halterung des Schneidklemmkontaktes aufweist.

Aus der deutschen Offenlegungsschrift DE 198 29 920 A1 ist ein derartiges elektrisches Gerät bekannt. Zur mechanischen Halterung von relativ großbauenden elektrischen Bauelementen sind am Boden eines Gehäuses Kunststofflaschen angeformt, die die Bauelemente zangenartig umgreifen. Zur Kontaktierung von Anschlussdrähten der Bauelemente sind Schneidklemmkontakte vorgesehen, die in am Gehäuse angeformte Haltetaschen einschiebbar sind. Die Schneidklemmkontakte bilden einstückig zugleich Einpresskontakte aus, die mit einer Leiterplatte verbindbar sind.

Diese, an sich vorteilhafte Befestigungsart der Bauelemente ist dann problematisch, wenn die elektrischen Bauelemente relativ schwer sind und/oder hohen mechanischen Belastungen durch Vibrationen oder Beschleunigungen ausgesetzt sind. Hierbei können sich die Bauelemente aus den Kunststofflaschen lösen oder sich innerhalb der Halterung verschieben, so dass die elektrische Verbindung zu den Schneidklemmkontakten mechanisch belastet oder sogar elektrisch unterbrochen wird.

Es stellte sich die Aufgabe, ein Gehäuse zu schaffen, an dem auch relativ große und schwere Bauelemente mechanisch besonders sicher gelagert und besonders einfach und sicher elektrisch kontaktiert werden können.

Diese Aufgabe wird erfindungsgemäß dadurch gelöst, dass das Gehäuse zur mechanischen Halterung des Bauelements eine Aufnahmekammer ausbildet, die die Mantelfläche des Bauelements zumindest abschnittsweise vollständig umschließt, dass ein radial verschwenkbarer Rastklips das in die Aufnahmekammer eingesetzte Bauelement in axialer Richtung fixiert, und dass der Schneidklemmkontakt mindestens einen Schneidklemmbereich aufweist, dessen Öffnungsrichtung in der Erstreckungsrichtung der Einpresskontakte ausgerichtet ist.

Besonders vorteilhaft ist es, dass der Schneidklemmkontakt derart geformt ist, dass die Öffnungsrichtung des mindestens einen Schneidklemmbereichs in der Erstreckungsrichtung der Einpresskontakte ausgerichtet ist. Hierdurch ist ein Kontaktieren eines Anschlusses des Bauelements und ein Verbinden des Schneidklemmkontakts mit der Leiterplatte in einem einzigen Arbeitsschritt möglich.

Relativ großbauende und schwere Bauelemente sind insbesondere elektrische Energiespeicher wie Batterien, Akkumulatoren oder auch Kondensatoren. Im folgenden wird, ohne Beschränkung der Allgemeinheit, eine im wesentlichen zylinderförmige Bauform solcher Bauelemente angenommen, wobei die erfindungsgemäßen Überlegungen auch ohne weiteres auf Bauelemente mit einer anderen geometrischen Ausgestaltung anwendbar bzw. übertragbar sind.

Durch die vollständige Umschließung der Mantelfläche, die auch abschnittsweise, d. h. nicht über die gesamte axiale Ausdehnung des Bauelements vorgesehen sein kann, ist das Bauelement in bezüglich seines Querschnitts radialen Richtungen, bis auf eventuell toleranzbedingte Abstände zwischen der Mantelfläche und dem umfassenden Gehäuse, schon weitgehend formschlüssig fixiert. Selbstverständlich kann auch vorgesehen werden, dass das Bauelement über seine gesamte axiale Ausdehnung von Wänden der Aufnahmekammer umfasst wird.

Die vorgenannten toleranzbedingte Abstände können vorteilhaft dadurch ausgeglichen werden, dass die Wände der Aufnahmekammer ins Innere der Aufnahmekammer hervorstehende Anformungen aufweisen, die federnd an Außenflächen des in die Aufnahmekammer eingesetzten Bauelements anliegen. Diese federnden Anformungen wirken dabei bei Bewegungen des Geräts als Schwingungsdämpfer für das Bauelement. Die hervorstehenden Anformungen sind dabei vorzugsweise einstückig an das Gehäuse angeformt.

Aufgrund der umlaufenden Umschließung der Aufnahmekammer durch Gehäusewände ist es erforderlich, das Bauselement in axialer Richtung in die Aufnahmekammer einzuschieben. Das Bauelement wird danach innerhalb der Aufnahmekammer durch einen radial verschwenkbaren Rastklips gesichert. Vorzugsweise ist der Rastklips am Rand der Aufnahmekammer derart angeordnet, dass er radial in die Aufnahmekammer hineinragt.

Zweckmäßigerweise weist der Rastklips eine in Richtung der Aufnahmekammer ansteigende Betätigungsschräge auf, an der das Bauelement beim axialen Einschieben in die Aufnahmekammer entlang geführt wird. Dadurch verschwenkt das Bauelement den Rastklips in radialer Richtung zum Querschnitt der Aufnahmekammer. Ist das Bauelement über den Rastklips hinweggeschoben, so federt der Rastklips zurück und sichert so das Bauelement axial in der Aufnahmekammer. Der Rastklips wird durch die Montage der Baugruppe auf eine, hier nicht dargestellte, Leiterplatte gegen Entriegeln gesichert.

Vorteilhafterweise kann die Aufnahmekammer oder das zu montierende Bauteil einen elastisch deformierbaren Körper, etwa in Form einer aus einem Elastomer bestehenden Dichtung, enthalten, der durch das Einschieben des Bauelements in die Aufnahmekammer zusammengepresst wird und der dadurch eine Rückstellkraft erzeugt, die das Bauelement gegen den Rastklips drückt. Hierdurch wird ein axialer Toleranzausgleich erzielt, durch den axiale Verschiebungen des Bauteils in der Aufnahmekammer verhindert werden.

Zum elektrischen Anschluss des Bauelements ist es vorteilhaft, wenn die Aufnahmekammer mindestens einen Durchbruch aufweist, durch den sich mindestens ein elektrischer Anschluss des Bauelements in den Bereich eines Einschubes zur Aufnahme eines Schneidklemmkontaktes erstreckt. Der Anschluss kann so durch einfaches Einsetzen des Schneidklemmkontaktes in den Einschub kontaktiert werden.

Besonders vorteilhaft ist es, wenn der Schneidklemmkontakt zwei zueinander parallele Schneidklemmbereiche aufweist, die beim Einsetzen des Schneidklemmkontaktes in den Einschub beide einen einzigen Anschluss des Bauelements kontaktieren. Durch diese doppelte Kontaktierung kann eine besonders sichere elektrische Anbindung des Bauelements erreicht werden.

Vorteilhaft ist es auch, einen an das Gehäuse anfügbaren Flachstecker vorzusehen, der mindestens einen Einpresskontakt aufweist, der mit der Leiterplatte verbindbar ist. Der Flachstecker hat dabei die Funktion, die Halterung der Leiterplatte an dem Gehäuse zu unterstützen. Der Flachstecker kann darüber hinaus eine elektrische Verbindung herstellen oder alternativ auch ohne eine elektrische Funktion sein. Der Flachstecker wird ebenfalls in einen am Gehäuse angeformten Einschub eingefügt und vorzugsweise durch ein aus der Ebene des Flachsteckers herausstehendes Federelement am Einschub gesichert.

Weitere vorteilhafte Ausgestaltungen und Weiterbildungen eines erfindungsgemäßen elektrischen Gerätes ergeben sich aus der nachfolgenden Beschreibung eines Ausführungsbeispieles anhand der Zeichnung.

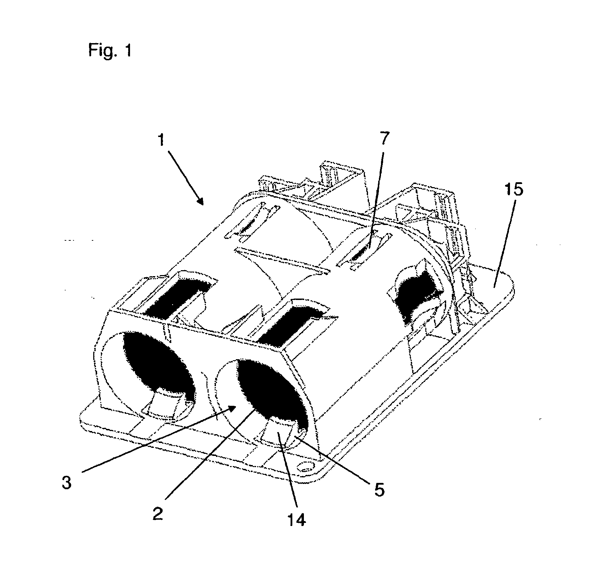

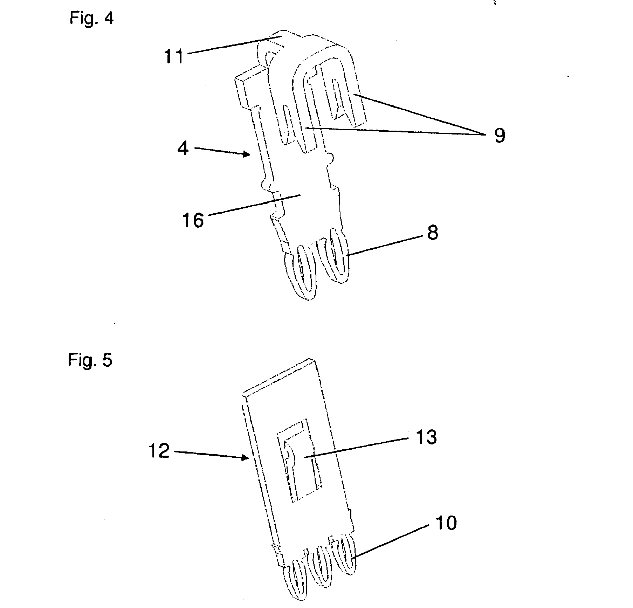

Die Figuren 1 bis 3 zeigen jeweils eine Ansicht eines erfindungsgemäß ausgebildeten elektrischen Gerätes. Die Figur 4 zeigt einen zum elektrischen Gerät gehörenden Schneidklemmkontakt; in der Figur 5 wird ein an das elektrische Gerät anfügbarer Flachstecker dargestellt.

Die Figur 1 zeigt ein elektrisches Gerät mit einem Gehäuse 1, welches einstückig aus Kunststoff geformt ist. Zu dem Gerät gehört eine elektrische Leiterplatte, die in dieser und den weiteren Figuren nicht erkennbar ist, und die man sich parallel unterhalb der Gehäusegrundfläche 15 angeordnet vorstellen kann.

Das Gehäuse 1 weist zwei angeformte, im wesentlichen zylinderförmige Aufnahmekammern 3 auf, in die jeweils ein elektrisches Bauelement 2, beispielsweise ein Akkumulator oder ein Kondensator, eingesetzt ist. Das Bauelement 2 ist in der Figur 1 durch seine dunkel dargestellte Außenflächen angedeutet.

Die Form des Gehäuses 1 ist an die Form und Größe der Bauelemente 2 angepasst, so dass diese nahezu passgenau in die Aufnahmekammern 3 eingefügt sind. Zum Ausgleich von Abmessungstoleranzen ist an den Wänden der Aufnahmekammern 3 mindestens eine federnde Anformung 7 angebracht, die in das Innere der Aufnahmekammern 3 hineinragt und an der Außenfläche des Bauelementes 2 anliegt. Durch seine Federwirkung wirkt die Anformung 7 bei mechanischen Belastungen des Gehäuses 1 als Schwingungsdämpfer für die in die Aufnahmekammern 3 eingesetzten Bauelemente 2.

An der Öffnungsseite jeder Aufnahmekammer 3 ist jeweils ein Rastklips 5 mit einer Betätigungsschräge 14 angeordnet, welcher federnd an das Gehäuse 1 angeformt ist. Beim Einschieben der Bauelemente 2 in die Aufnahmekammern 3 wird das jeweilige Bauelement 2 gegen die Betätigungsschräge 14 des sich vor der zugehörigen Aufnahmekammer 3 befindlichen Rastklips 5 gedrückt, wodurch der federnd angeordnete Rastklips 5 nach unten verschwenkt wird. Nachdem das Bauelement 2 über den Rastklips 5 hinweggeschoben wurde und sich vollständig in der Aufnahmekammer 3 befindet, federt der Rastklips 5 in seine Ausgangslage zurück und arretiert dadurch das Bauelement 2 in der Aufnahmekammer 3. Damit sind auch relativ schwere Bauelemente 2 sicher innerhalb der Aufnahmekammern 3 des Gehäuses 1 fixiert.

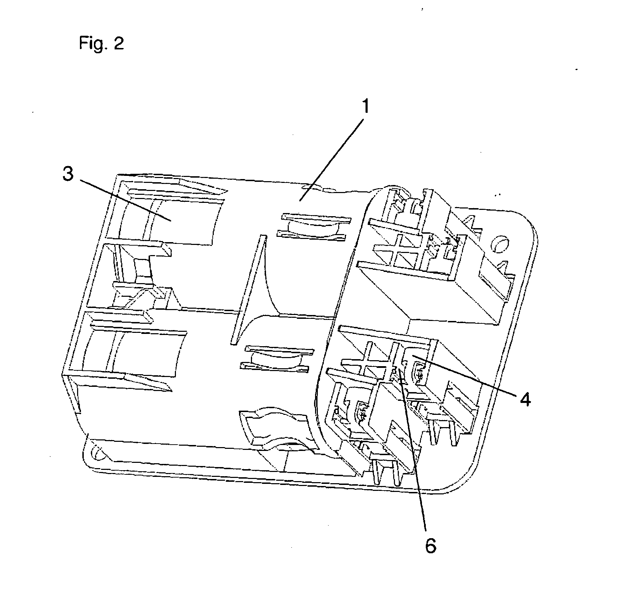

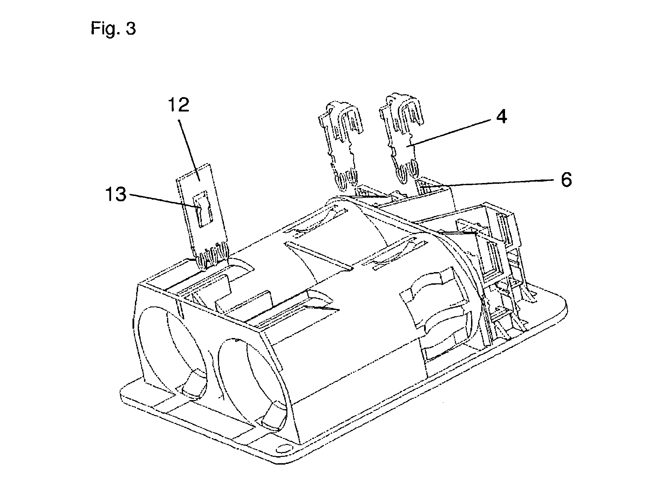

Zur elektrischen Anbindung der Bauelemente 2 weist das Gehäuse 1 mehrere Einschübe 6 für Schneidklemmkontakte 4 auf. Dieses ist besonders deutlich in der Figur 2 erkennbar. Die Schneidklemmkontakte 4 kontaktieren, in den Figuren nicht dargestellte Anschlüsse der Bauelemente 2, die beispielsweise als Anschlussdrähte ausgeführt sind, und die sich, durch einen oder mehrere Durchbrüche in den Aufnahmekammern 3, bis in die Einschübe 6 erstrecken. Die Schneidklemmkontakte 4 sind in den Figuren 3 und 4 als Einzelteile dargestellt. Die Figur 3 zeigt zwei Schneidklemmkontakte 4 über Einschüben 6 unmittelbar vor dem Anfügen an das Gehäuse 1. Die Figur 4 stellt die vergrößerte Ansicht eines einzelnen Schneidklemmkontaktes 4 dar. Dieser weist zwei zueinander parallele Schneidklemmbereiche 9 auf, die beide einen Anschluss eines Bauelements kontaktieren können. Durch die doppelte Kontaktierung wird eine besonders sichere elektrische Anbindung mit einem besonders geringen Übergangswiderstand erzielt.

Die Schneidklemmbereiche 9 sind über einen abgewinkelten Verbindungsabschnitt 11 einstückig mit einem ebenen Abschnitt 16 verbunden, wobei der ebene Abschnitt 16 so geformt ist, dass er stabilen Halt in einem Einschub 6 (siehe Figur 2) des Gehäuses 1 finden kann. An der dem Verbindungsabschnitt 11 gegenüberliegenden Seite des ebenen Abschnitts 16 sind zwei Einpresskontakte 8 angeformt.

Vorteilhaft ist, dass die Öffnungsrichtungen der Schneidklemmbereiche 9 parallel zur Erstreckungsrichtung der Einpresskontakte 8 ausgerichtet sind. Hierdurch werden, beim Einfügen eines Schneidklemmkontaktes 4 in einen Einschub 6, zugleich sowohl die Verbindungen der Schneidklemmbereiche 9 mit einem Anschluss eines Bauelements 2 hergestellt, als auch die Einpresskontakte 8 in die zugehörigen Durchkontaktierungen der Leiterplatte eingesetzt. Die Kontaktierung und elektrische Anbindung eines Bauelementanschlusses erfolgt somit auf einfache Weise in einem einzigen Arbeitsschritt.

Neben der lötfreien elektrischen Anbindung der Bauelemente 2 an die Leiterplatte, kann durch die Einpresskontakte 8 zugleich eine mechanische Verbindung zwischen dem Gehäuse 1 und der Leiterplatte hergestellt werden.

Zur Befestigung der Leiterplatte kann zudem mindestens ein Flachstecker 12 vorgesehen sein, der mehrere Einpresskontakte 10 zur Anbindung an die Leiterplatte aufweist. Einen derartigen Flachstecker 12 mit drei angeformten Einpresskontakten 10 zeigt die Figur 5 als ein Einzelteil. Der Flachstecker 12 weist zudem ein angeformtes Federelement 13 auf, welches aus der Ebene des Flachsteckers herausragt. Das Federelement 13 dient zur Sicherung des Flachsteckers in einem Einschub des Gehäuses 1.

Der Flachstecker 12 kann eine elektrische Funktion haben und beispielsweise die Mantelfläche eines der Bauelemente 2 kontaktieren oder auch, ohne eine elektrische Funktion zu erfüllen, lediglich zur zusätzlichen Befestigung der Leiterplatte am Gehäuse 1 vorgesehen sein.

### Bezugszeichen

- 1: Gehäuse
- 2: Bauelement(e)
- 3: Aufnahmekammer(n)
- 4: Schneidklemmkontakt
- 5: Rastklips
- 6: Einschub (bzw. Einschübe)
- 7: Anformungen
- 8: Einpresskontakte
- 9: Schneidklemmbereich(e)
- 10: Einpresskontakte
- 11: Verbindungsabschnitt
- 12: Flachstecker
- 13: Federelement
- 14: Betätigungsschräge
- 15: Gehäusegrundfläche
- 16: ebener Abschnitt

## Patentansprüche

1. Elektrisches Gerät
mit einem Gehäuse und einer am Gehäuse mechanisch gehaltenen Leiterplatte,
und mit mindestens einem am Gehäuse mechanisch gehaltenen großen und schweren elektrischen oder elektronischen Bauelement wie einer Batterie, einem Akkumulator oder einem Kondensator, von dessen Anschlüssen wenigstens einer über einen Schneidklemmkontakt, der zugleich Einpresskontakte ausbildet, elektrisch mit der Leiterplatte verbunden ist,
wobei das Gehäuse mindestens einen angeformten Einschub zur Halterung des Schneidklemmkontaktes aufweist,
**dadurch gekennzeichnet,**
**dass** das Gehäuse (1) zur mechanischen Halterung des Bauelements (2) eine Aufnahmekammer (3) ausbildet, die die Mantelfläche des Bauelements (2) zumindest abschnittsweise vollständig umschließt,
**dass** ein radial verschwenkbarer Rastklips (5) das in die Aufnahmekammer (3) eingesetzte Bauelement (2) in axialer Richtung fixiert, und
**dass** der Schneidklemmkontakt (4) mindestens einen Schneidklemmbereich (9) aufweist, dessen Öffnungsrichtung in der Erstreckungsrichtung der Einpresskontakte (8) ausgerichtet ist.

2. Elektrisches Gerät nach Anspruch 1, **dadurch gekennzeichnet, dass** das Bauelement (2) über seine gesamte axiale Ausdehnung von Wänden der Aufnahmekammer (3) umfasst wird.

3. Elektrisches Gerät nach Anspruch 1, **dadurch gekennzeichnet, dass** die Wände der Aufnahmekammer (3) ins Innere der Aufnahmekammer (3) hervorstehende Anformungen (7) aufweisen, die federnd an Außenflächen des in die Aufnahmekammer (3) eingesetzten Bauelements (2) anliegen.

4. Elektrisches Gerät nach Anspruch 1, **dadurch gekennzeichnet, dass** der radial federnder Rastklips (5) in die Aufnahmekammer (3) hineinragt.

5. Elektrisches Gerät nach Anspruch 4, **dadurch gekennzeichnet, dass** der Rastklips (5) eine in Richtung der Aufnahmekammer (3) ansteigende Betätigungsschräge (14) aufweist, an der das Bauelement (2) beim axialen Einschieben in die Aufnahmekammer (3) entlang geführt wird.

6. Elektrisches Gerät nach Anspruch 1, **dadurch gekennzeichnet, dass** die Aufnahmekammer (3) mindestens einen Durchbruch aufweist, durch den sich mindestens ein Anschluss des Bauelements (2) in den Bereich eines Einschubs (6) zur Aufnahme eines Schneidklemmkontaktes (4) erstreckt.

7. Elektrisches Gerät nach Anspruch 1, **dadurch gekennzeichnet, dass** der Schneidklemmkontakt (4) zwei zueinander parallele Schneidklemmbereiche (9) aufweist.

8. Elektrisches Gerät nach Anspruch 1, **dadurch gekennzeichnet, dass** ein an das Gehäuse (1) anfügbarer Flachstecker (12) vorgesehen ist, der mindestens einen Einpresskontakt (10) aufweist, der mit der Leiterplatte verbindbar ist.

9. Elektrisches Gerät nach Anspruch 8, **dadurch gekennzeichnet, dass** der Flachstecker (12) ein hervorstehendes Federelement (13) aufweist.

10. Elektrisches Gerät nach Anspruch 1, **dadurch gekennzeichnet, dass** das Bauelement (2) ein elektrischer Energiespeicher ist.

11. Elektrisches Gerät nach Anspruch 1, **dadurch gekennzeichnet, dass** die an das Gehäuse (1) montierte Leiterplatte die Verschwenkbarkeit des Rastklips (5) einschränkt oder aufhebt.

12. Elektrisches Gerät nach Anspruch 1, **dadurch gekennzeichnet, dass** die Aufnahmekammer einen Körper enthält, der durch das eingesetzte Bauelement (2) elastisch deformiert wird.

13. Elektrisches Gerät nach Anspruch 12, **dadurch gekennzeichnet, dass** der Körper eine aus einem Elastomer bestehende Dichtung ausbildet.

## Claims

1. Electrical device
having a housing and a printed circuit board which is mechanically retained on the housing
and having at least one large, heavy electrical or electronic component, such as a battery, a rechargeable battery or a capacitor, which is mechanically retained on the housing and of which at least one of the terminals is electrically connected to the printed circuit board by way of an insulation displacement contact that simultaneously constitutes press-in contacts,
with the housing having at least one moulded-on insert for the purpose of retaining the insulation displacement contact,
**characterised in that**
the housing (1) constitutes a retention chamber (3) which is intended for mechanically retaining the component (2) and which completely encompasses the outer surface of the component (2) , at least section-wise,
that a radially pivotable latching clip (5) secures the component (2) inserted into the retention chamber (3) in the axial direction, and
that the insulation displacement contact (4) has at least one insulation displacement zone (9) whose direction of opening is aligned to the direction of expansion of the press-in contacts (8).

2. Electrical device according to Claim 1, **characterised in that** the component (2) is encompassed over its entire axial dimension by walls of the retention chamber (3).

3. Electrical device according to Claim 1, **characterised in that** the walls of the retention chamber (3) have moulded-on members (7) that project into the interior of the retention chamber (3) and come to rest in a resilient manner on outer surfaces of the component (2) inserted into the retention chamber (3).

4. Electrical device according to Claim 1, **characterised in that** the radially resilient latching clip (5) projects into the retention chamber (3).

5. Electrical device according to Claim 4, **characterised in that** the latching clip (5) has an activating bevel (14) which rises in the direction of the retention chamber (3) and along which the component (2) is guided during the axial insertion into the retention chamber (3).

6. Electrical device according to Claim 1, **characterised in that** the retention chamber (3) has at least one breakthrough through which at least one termination of the component (2) extends into the area of an insert (6) for the purpose of holding an isolation displacement contact (4).

7. Electrical device according to Claim 1, **characterised in that** the insulating displacement contact (4) has two insulation displacement zones (9) parallel to each other.

8. Electrical device according to Claim 1, **characterised in that** a blade terminal (12) is provided which can be appended to the housing (1) and has at least one press-in contact (10) that can be connected to the printed circuit board.

9. Electrical device according to Claim 8, **characterised in that** the blade terminal (12) has a protruding spring element (13).

10. Electrical device according to Claim 1, **characterised in that** the component (2) is an electrical energy storage device.

11. Electrical device according to Claim 1, **characterised in that** the printed circuit board mounted on the housing (1) restricts or cancels the pivoting capability of the latching clip (5).

12. Electrical device according to Claim 1, **characterised in that** the retention chamber incorporates an element which is elastically deformed by the inserted component (2).

13. Electrical device according to Claim 12, **characterised in that** the element constitutes a seal made of elastomer.

## Revendications

1. Appareil électrique, comprenant
un boîtier et une plaque de circuit imprimé, maintenue mécaniquement sur ledit boîtier,
et au moins un gros et lourd composant électrique ou électronique, tels qu'une batterie, un accumulateur ou un condensateur, maintenu mécaniquement sur le boîtier, dont au moins l'un des raccords est relié électriquement à la plaque de circuit imprimé, par l'intermédiaire d'une borne autodénudante, qui est simultanément réalisée en forme de borne de borne à insérer,
sachant que le boîtier présente au moins un logement pour maintenir la borne autodénudante,
**caractérisé en ce que**,
pour le maintien mécanique du composant (2), le boîtier (1) forme un compartiment de réception (3), qui enveloppe complètement, au moins par sections, la surface latérale du composant (2),
un clip de fixation (5), pouvant pivoter radialement, fixe, dans la direction axiale, le composant (2) inséré dans le compartiment de réception (3), et
que la borne autodénudante (4) présente au moins une zone autodénudante (9), dont la direction d'ouverture est orientée dans la direction, dans laquelle s'étendent les bornes à insérer (8).

2. Appareil électrique selon la revendication 1, **caractérisé en ce que** le composant (2) est entouré sur toute sa dimension axiale par les parois du compartiment de réception (3).

3. Appareil électrique selon la revendication 1, **caractérisé en ce que** les parois du compartiment de réception (3) présentent des parties faonnées (7), qui, faisant saillie à l'intérieur dudit compartiment de réception (3), portent élastiquement contre les faces extérieures du composant (2), inséré dans le compartiment de réception (3).

4. Appareil électrique selon la revendication 1, **caractérisé en ce que** le clip de fixation (5) radialement élastique fait saillie dans le compartiment de réception (3).

5. Appareil électrique selon la revendication 4, **caractérisé en ce que** le clip de fixation (5) présente un chanfrein d'actionnement (14) en pente ascendante en direction du compartiment de réception (3), le long duquel le composant (2) est guidé lors de l'insertion axiale dans ledit compartiment de réception (3).

6. Appareil électrique selon la revendication 1, **caractérisé en ce que** le compartiment de réception (3) présente au moins un passage, à travers lequel au moins un raccord du composant (2) s'étend dans la région d'un tiroir d'enfichage (6), pour la réception d'une borne autodénudante (4).

7. Appareil électrique selon la revendication 1, **caractérisé en ce que** la borne autodénudante (4) présente deux zones autodénudantes (9) parallèles l'une à l'autre.

8. Appareil électrique selon la revendication 1, **caractérisé en ce qu'**est prévu une fiche plate (12), qui, pouvant être adjointe au boîtier (1), présente au moins une borne à insérer (10), qui peut être raccordée à la plaque de circuit imprimé.

9. Appareil électrique selon la revendication 8, **caractérisé en ce que** la fiche plate (12) présente au moins un élément élastique (13) saillant.

10. Appareil électrique selon la revendication 1, **caractérisé en ce que** le composant (2) est un accumulateur d'énergie électrique.

11. Appareil électrique selon la revendication 1, **caractérisé en ce que** la plaque de circuit imprimé, montée sur le boîtier (1), limite ou annule le pivotement du clip de fixation (5).

12. Appareil électrique selon la revendication 1, **caractérisé en ce que** le compartiment de réception contient un corps, qui est déformé élastiquement par le composant (2) inséré.

13. Appareil électrique selon la revendication 12, **caractérisé en ce que** le corps forme un joint d'étanchéité, qui consiste en élastomère.
